# EUROPEAN PATENT APPLICATION

(11) **EP 1 947 220 A1**
(43) Date of publication of application: **23.07.2008**
(21) Application number: 06746977.5
(22) Date of filing: 29.05.2006
(51) Int. Cl.: C30B 29/04, C30B 33/12, H01M 4/02, H01M 4/58, H01M 4/96

(54) **PROCESS FOR PRODUCING DIAMOND HAVING STRUCTURE OF ACICULAR PROJECTION ARRAY DISPOSED ON SURFACE THEREOF, DIAMOND MATERIAL, ELECTRODE AND ELECTRONIC DEVICE**

(30) Priority: 19.10.2005 JP 2005304526
(71) Applicant: Central Japan Railway Company, Nagoya-shi, Aichi 450-6101 (JP)
(72) Inventor: TERASHIMA, Chiaki, Nagoya-shi Aichi 450-6101 (JP); ARIHARA, Kazuki, Nagoya-shi Aichi 450-6101 (JP); FUJISHIMA, Akira, Nagoya-shi Aichi 450-6101 (JP)
(74) Representative: Roth, Klaus
(86) International application number: PCT/JP2006/310699
(87) International publication number: WO 2007/046165

(57) **Abstract**

A method and the others for producing a diamond having a highly minute acicular projection structure on a surface thereof, which is applicable to materials with various shapes while simplifying the producing process, are provided. An acicular projection array structure (3) is formed on a surface of a diamond base material (2a), by treating the surface of the diamond base material by dry etching using oxygen gas. At least one dopant selected among boron (B), nitrogen (N), aluminum (Al), silicon (Si), phosphorus (P), sulfur (S), copper (Cu), arsenic (As), molybdenum (Mo), platinum (Pt) and gold (Au) is doped with a concentration of 1 × 10¹⁹ atoms/cm³ and more at least in a region near the surface of the diamond base material.

## Description

### TECHNICAL FIELD

The present invention relates to a method for producing a diamond having a highly minute acicular projection array structure, which is suitable as a wide range of electrode materials or the like, on the surface thereof.

### BACKGROUND ART

It is expected that a carbon material is applied to a cathode for a lithium secondary battery, an electrode for a fuel cell, an electrode for electron emission, an electrode for industrial electrolysis, an electrode for a chemical sensor, an electrode for an electronic device, an electron emission device or the like. Large surface area of carbon material with acicular projection array structure is suitable for the above-mentioned applications.

Carbon has both ordered structure and unordered structure, mainly composed of SP² and SP³ bonded. Four allotropes which are derived from such structure, noncrystalline carbon (amorphous), graphite, fullerene and diamond, are known. Among carbon materials including these allotropes, a diamond is applied as a most practical industrial material in a wide range of fields, since it has high hardness and high thermal conductivity.

In addition, there is a tremendous amount of attempts recently to obtain a diamond with electrical conductivity by adding impurities. For example, resistivity of a diamond in which boron or phosphorus is doped can be changed according to a doped amount, showing conductivity from that of a semiconductor to that of a conductor. Main characteristics of a diamond material including such conductive diamond include excellent mechanical strength, chemical stability, a very wide potential window in which oxidative decomposition and reductive decomposition of a solvent are difficult to be generated, excellent corrosion resistance, or the like. These characteristics are unique to such diamond material.

For this reason, a conductive diamond is actively applied to an electrode for a chemical sensor or an electrode for industrial electrolysis. With respect to a conductive diamond used for such applications, it is known that a structure in which a plurality of acicular projections are arranged on the surface thereof is suitable as an electrode material, since it can have a larger reaction field than a flat diamond film on the surface thereof.

In addition, a diamond is one of a few substances having a negative electron affinity. Recently, a research on an application of a diamond material to an electron emission device is actively conducted, focusing attention on its negative electron affinity. In case of electron emission device, also, a device including a diamond having a structure in which a plurality of acicular projections are arranged on the surface thereof can have higher electron emission efficiency than that with a flat surface, because the electron field is easily focused onto an acicular projection part.

Heretofore, a porous carbon material having conductivity such as active carbon, and an electrode having a catalyst layer with the porous carbon material as a support have been used as electrodes for a fuel cell, a secondary battery and an electric double layer capacitor (a supercapacitor). Although such conventional electrodes are suitable in terms of conductivity and large surface area, since a porous carbon material has lower mechanical strength, a porosity of a porous body has so far a tendency to decline under a mechanical pressure in molding. Since the declined porosity of a porous carbon material means smaller reaction area thereof, the electrode performance declines. From such a point of view, a conductive diamond (in which a plurality of acicular projections are arranged) having excellent mechanical strength and large reaction area is also desired to be realized.

As mentioned above, a structural control of a diamond surface is a very important issue in an industrial utilization of a diamond, and heretofore, a variety of related technologies have been proposed. For example, Patent Document 1 discloses a technology of forming acicular projections on the surface of a diamond film by a micro-wave plasma CVD method using hydrogen gas. Patent Document 2 discloses a technology in which a mask having a resistance to oxygen plasma is formed on the surface of a diamond substrate by a photolithography technology in order to control a shape and an arrangement of the formed projection, and reactive ion etching using oxygen gas is performed to the formed mask to thereby form projections corresponding to a mask position.
Patent Document 1: Unexamined Japanese Patent Publication No. 2001-348296
Patent Document 2: Unexamined Japanese Patent Publication No. 2002-75171

### DISCLOSURE OF THE INVENTION

### PROBLEM TO BE SOLVED BY THE INVENTION

As a method for synthesizing a diamond film, a micro-wave plasma chemical vapor deposition (CVD) method, for example, is known. A diamond film generated by the micro-wave plasma CVD method or the like is a polycrystalline film in which diamond particles are aggregated. Furthermore, by controlling synthesis conditions, a diamond film including a mixture of diamond, diamond-like carbon and amorphous carbon can be synthesized.

The method for treating the surface of a diamond film including a mixture of diamond, diamond-like carbon and amorphous carbon by hydrogen plasma (see Patent Document 1) is to form an acicular projection structure by a crystal face orientation or a difference in an etching rate in a crystal grain, a crystal grain boundary, a defect part or the like. Therefore, a distribution of acicular projections depends on a structure of a diamond film, and it is difficult to control a structure. For example, it is difficult to uniformly distribute acicular projections or to arrange the projections in a high density. It is also difficult to increase an aspect ratio of acicular projections.

When a diamond having an acicular projection array structure on the surface thereof is applied to an electron emission device, since a nonuniform distribution of acicular projections or a low array density cause the number of emission points to decrease, an increase of a current density is limited. Furthermore, since a low array density or a low aspect ratio disadvantageously inhibits a surface area to become larger, such material is not suitable for an electrode for a fuel cell or an electrode for industrial electrolysis which requires a large reactive field.

Although a method in which a mask having a resistance to oxygen plasma is formed on a diamond substrate surface and then reactive ion etching is performed on the formed mask (see Patent Document 2) makes it possible to control a shape and an array of the formed projections, many processes including a photolithography process of forming a mask and a process of removing the mask after projections are formed are required.

Since projections formed by etching using a mask formed by a photolithography technology have a pillar shaped structure having a large radius of curvature at its tip, such method is not suitable for an electron emission source. Furthermore, since a size and an array density of the formed projections are dependent on a resolution of the photo mask to be used, miniaturization and densification of the formed projections are limited.

Also, a photolithography technology is applicable to a flat-shaped two-dimensional material, but not applicable to a three-dimensional material such as a spherical-shaped material.

The present invention is made in consideration of the above issues. The purpose is to provide a method for producing a diamond having a highly minute acicular projection array structure on the surface thereof which is applicable to materials with various shapes while simplifying the producing process.

### MEANS FOR SOLVING THE PROBLEM

A method for producing a diamond having an acicular projection array structure on the surface thereof according to Claim 1 to be made to solve the above problems comprises the step of forming an acicular projection array structure on the surface of a diamond base material by treating the surface of the diamond base material by dry etching using oxygen gas (for example, etching using plasma such as plasma etching and reactive ion etching) to the diamond base material in which at least one dopant selected among boron (B), nitrogen (N), aluminum (Al), silicon (Si), phosphorus (P), sulfur (S), copper (Cu), arsenic (As), molybdenum (Mo), platinum (Pt) and gold (Au) is doped (added) with a concentration of 1 × 10¹⁹ atoms/cm³ and more at least in a region near the surface of the diamond base material.

Here, in the above description "at least one dopant...is doped...at least in a region near the surface of the diamond base material," the region in which at least one dopant is added may be only the region near the surface of the diamond base material up to an arbitrary depth from the surface thereof (for example, approximately 0.1 to 0.5 µ m) or may be the whole diamond base material.

Heretofore, it is known that dry etching using oxygen gas has a high etching effect to a carbon material including a diamond, due to the actions of ion and radical included in oxygen plasma. However, when etching using oxygen plasma is performed to a carbon material, the surface of the carbon material is uniformly etched, or a few recesses/projections are only generated (see Paragraph [0008] of Patent Document 1). Therefore, as shown in FIG. 7, a pretreatment process such as photolithography treatment has been required in order to form an acicular projection array structure by etching using oxygen plasma.

The inventors of the present application found that a structure in which nano-order acicular projections are regularly arranged is formed on the surface of a diamond by performing dry-etching using oxygen gas to a diamond in which each of the above dopants, such as boron, is added with a concentration of 1×10¹⁹ atoms/cm³. Here, although an upper limit of a dopant concentration to be added in a diamond in order to form a good acicular projection array structure is not specifically limited, since a limit concentration with which a dopant may be added in a diamond is approximately 1 × 10²³ atoms/cm³, it is determined that an acicular projection array structure can be formed on the surface of a diamond with a dose amount below the limit concentration. A committed research by the inventors of the present application showed that a dopant concentration suitable to obtain a better shaped acicular projection array structure is approximately 3 × 10²⁰ atoms/cm³ to 8 × 10²¹ atoms/cm³.

When etching using oxygen plasma is performed to a diamond base material in which each of the above dopants, such as boron, is added, oxides generated when a dopant near the surface of the diamond base material unites with oxygen included in plasma, or dopant atoms themselves, act as a mask having a resistance to oxygen plasma. Under the influence of the mask, etching using oxygen plasma selectively progresses, thereby to form an acicular projection array structure on the surface of the diamond base material.

With respect to a dopant species to be added to a diamond, a dopant with which characteristics suitable for an intended use of a diamond to be produced can be achieved may be used. For example, when a diamond material with characteristics of a p-type semiconductor is produced, a p-type dopant, such as boron, can be used. When a diamond material with characteristics of an n-type semiconductor is produced, an n-type dopant, such as phosphorus, can be used.

Since a method for producing a diamond having an acicular projection array structure on the surface thereof in the present invention does not require processes such as photolithography treatment when etching using oxygen plasma is performed, productivity can be substantially improved. Furthermore, since a dopant present near the surface of the diamond base material acts as a highly minute mask at an atomic level, an acicular projection array structure in which minuteness and aspect ratio are significantly higher than those of acicular projections formed by lithography treatment can be formed. Therefore, a diamond with excellent electrode characteristics due to its wider surface area, and further with excellent electron emission capabilities due to acicular projections with high minuteness and aspect ratio, can be provided.

Moreover, an array density of a mask by a dopant present on the diamond surface changes by changing a dopant concentration. In other words, since an array density of acicular projections formed on the diamond surface can be governed by controlling a dopant concentration incorporated into a diamond, a diamond material having a surface shape suitable for an application can be provided. Also, since the method for producing a diamond in the present invention does not require processes such as photolithography treatment, it is applicable to not only a planar two-dimensional material but also to a three-dimensional (such as spherical) material.

Any etching method, such as reactive ion etching using radio-frequency as a plasma generating source, reactive beam etching, and reactive ion etching using micro wave as a plasma generating source, can be used as a treatment for etching a diamond base material by using oxygen plasma. For example, when etching a diamond base material by reactive ion etching using radio-frequency as a plasma generating source, an acicular projection array structure can be formed on the surface of a diamond base material by performing etching in an oxygen gas atmosphere under a pressure of 5 to 100 Pa. In addition, as a result of further studies, it has become clear that an oxygen gas pressure suitable for obtaining an acicular projection array structure having a better shape is around 20 Pa.

A method for producing a diamond used as a base material is not limited to a chemical vapor deposition method such as micro-wave plasma CVD and hot filament CVD, but may be a high pressure high temperature method. A dopant may be incorporated into a diamond during a process of producing the diamond as a base material, or may be added by ion implantation after the diamond synthesis.

When etching treatment using oxygen plasma is performed to a diamond, a diamond surface is terminated by oxygen. By applying gases such as oxygen gas, nitrogen gas, chlorine gas, noble gas, and perfluorocarbon gas to the oxygen-terminated diamond surface, the diamond termination can be reformed by these gasses. The term "reformed" used herein means that oxygen on the oxygen-terminated diamond surface is replaced by a gas element to be applied.

Accordingly, by experiencing a process of reforming the surface termination of acicular projections by gases such as oxygen gas, nitrogen gas, chlorine gas, noble gas, and perfluorocarbon gas after a process of forming an acicular projection array structure by etching using oxygen plasma, a diamond material having different characteristics can be provided depending on a gas species to be applied.

For example, by applying hydrogen plasma or performing hydrogen annealing treatment to the oxygen-terminated diamond surface, the diamond surface can be hydrogen-terminated. The hydrogen-terminated diamond has higher negative electron affinity and electron emission capabilities than an oxygen-terminated diamond. In other words, by experiencing a process of hydrogen-terminating the surface of acicular projections after a process of forming an acicular projection array structure by etching using oxygen plasma, a diamond with higher electron emission capabilities can be provided.

An electrode including a diamond material produced by the method for producing a diamond in the present invention has an excellent electrode characteristics with larger surface area due to an acicular projection array structure having high minuteness and aspect ratio. Therefore, this electrode is suitably applicable as a cathode for a lithium secondary battery, an electrode for a fuel cell, an electrode for ozone generation, an electrode for industrial electrolysis, an electrode for a chemical sensor, or an electrode for electron emission.

Also, an electronic device including, as a component, a diamond material produced by the method for producing a diamond in the present invention (an individual part which becomes a component of an equipment, an electronic circuit or the like with separate unique functions) has dramatically improved capabilities compared with the conventional devices, since the diamond material has a larger surface area and excellent electron emission capabilities. In particular, this diamond material is suitably applicable as a component of a lithium secondary battery, a fuel cell, an electric double layer capacitor, an electrolytic cell, a chemical sensor or an electron emission device.

### BRIEF DESCRIPTION OF THE DRAWINGS

FIG. 1(a) is a schematic view showing a process of producing a diamond having an acicular projection array structure on the surface thereof (Embodiment 1), and FIG. 1(b) is a schematic top view showing an acicular projection array structure formed in a diamond film.
FIG. 2 is an electron microscope image of the surface of a boron-doped diamond film after etching treatment using oxygen plasma is performed.
FIG. 3 is an electron microscope image of the surface of a boron-doped diamond film after etching treatment using oxygen plasma is performed, in case that a density of the doped boron is low.
FIG. 4 is a schematic view showing a process of producing a diamond device applicable as an electronic device such as an electron emission device or a chemical sensor (Embodiment 2).
FIG. 5 is a schematic view of a process of producing a diamond device in case that acicular projections are formed by adding a dopant through ion implantation after a diamond film synthesis (Embodiment 3).
FIG. 6A is a photograph showing that a water droplet was dropped using a needle on the surface of a diamond acicular projection before hydrogen plasma treatment, and FIG. 6B is a photograph showing that a water droplet was dropped using a needle on the surface of a diamond acicular projection after hydrogen plasma treatment.

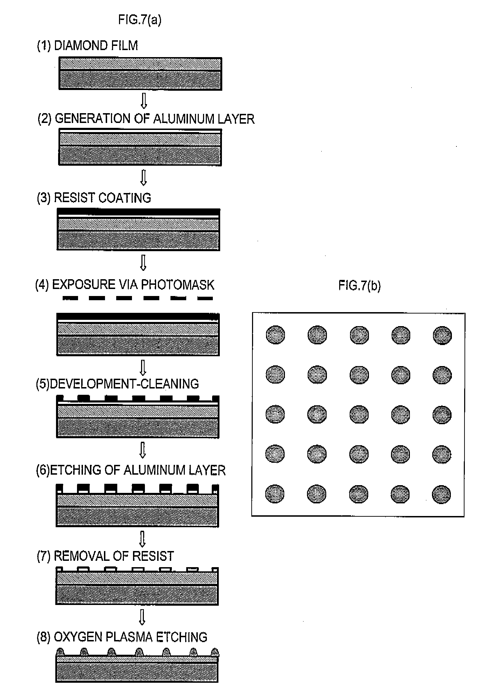

FIG. 7(a) is a schematic view showing a conventional producing process in which pretreatment processes such as photolithography treatment are performed in order to form an acicular projection array structure by etching using oxygen plasma, and FIG. 7(b) is a schematic top view showing an acicular projection array structure formed on a diamond film by the conventional producing method.

### EXPLANATION OF REFERENCE NUMERALS

- 1: substrate,
- 2: diamond film,
- 2a: boron-doped diamond film,
- 2b: doped diamond film,
- 2c: diamond region in which a dopant is implanted,
- 3: acicular projections,
- 4: insulating layer,
- 5: insulating and protecting layer

### BEST MODE FOR CARRYING OUT THE INVENTION

Embodiments of the present invention are described below based on drawings.

### [First Embodiment]

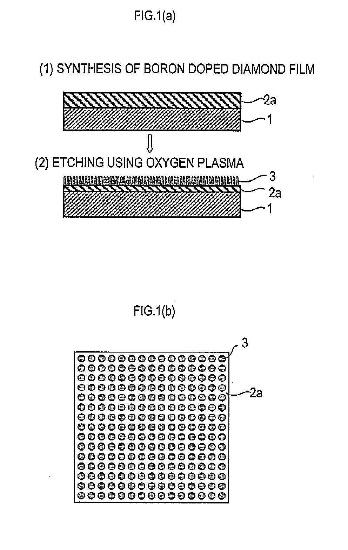

FIG. 1(a) is a schematic view showing a process of producing a diamond having an acicular projection array structure on the surface thereof (First Embodiment).

Firstly, as shown in (1) of FIG. 1(a), a boron-doped diamond film 2a, to which boron is incorporated, is generated on a substrate 1. An example of the methods for generating the boron-doped diamond film 2a includes a micro-wave plasma CVD method. Firstly, diamond seed crystals are applied on the substrate 1 (n-Si(111) substrate in the present embodiment) by mechanical polishing. Then, a gas is obtained by bubbling with hydrogen gas a solution (boron solution) in which boron oxide is dissolved in an acetone-methanol mixture solution. Using the obtained gas as sources of carbon and boron by the micro-wave plasma CVD method, the boron doped diamond film 2a is synthesized on the substrate 1.

In an experiment conducted by the inventors of the present invention, under conditions of a B/C ratio of 10⁴ ppm in the above boron solution and a microwave frequency of 2.45 GHz, a boron-doped diamond film having a thickness of approximately 18 µm was obtained after 7 hours of the operation process. In other words, film growth rate was 2.6 µm/h. Boron atoms were uniformly distributed within the synthesized boron-doped diamond film, and it was determined from the results of a SIMS (Secondary Ion Mass Spectrometry) that a concentration of the boron atoms is approximately 2× 10²¹ atoms/cm³.

Next, as shown in (2) of FIG. 1(a), etching using oxygen plasma is performed on the surface of the boron-doped diamond film 2a obtained in the above (1) to form a number of acicular projections 3 on the surface of the boron-doped diamond film 2a. An example of the methods for performing etching using oxygen plasma includes reactive ion etching using radio-frequency as a plasma generating source. Firstly, the substrate 1 on which the boron-doped diamond film 2a is deposited is placed on an electrode of a parallel plate type reactive ion etching equipment, and, using 100% oxygen gas as an etching gas, etching is performed at radio-frequency of 13.56 MHz and of radio-frequency output of 300 W in the atmosphere of gas pressure of approximately 20 Pa. By this etching process, as shown in (2) of FIG. 1(a) and FIG. 1(b), a structure in which acicular projections 3 are regularly arranged at high density is formed on the surface of the boron-doped diamond film 2a.

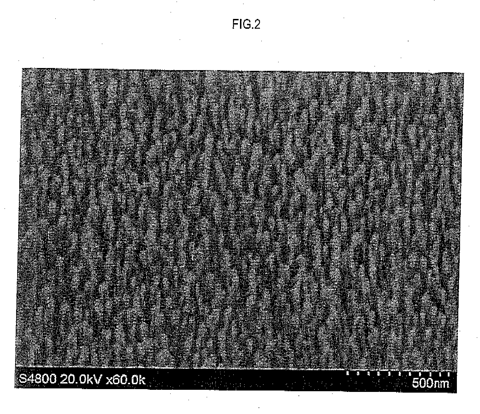

With respect to the boron-doped diamond film (boron concentration: approximately 2 × 10²¹ atoms/cm³) obtained in the above-mentioned experiment, the inventors of the present invention conducted a treatment by reactive ion etching for 15 minutes under conditions of oxygen gas pressure of 20 Pa, radio-frequency of 13.56 MHz and radio-frequency output of 300 W. After the etching treatment, the surface of the boron-doped diamond film was observed using a scanning electron microscope. It was observed that diamond acicular projections having an average diameter of approximately 25 nm are formed at high density of 3.8 × 10¹⁰ projections/cm². Height of the formed diamond acicular projections ranges around 0.2 µm to 3µm depending on an etching time. Aspect ratio of the formed diamond acicular projections ranges around 10 to 100, showing that higher aspect ratio can be achieved. Furthermore, as a result of a measurement by Raman spectroscopy, it was found that there is no difference in spectral shapes before and after etching. Therefore, it was confirmed that even if an acicular projection array structure is formed on the surface of a diamond by etching, the acicular projections and films themselves maintain a diamond structure. FIG. 2 shows an electron microscope image of the surface of the boron-doped diamond film after the etching treatment.

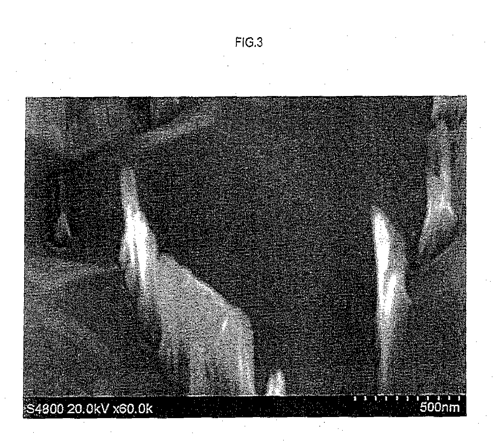

For comparative reviews, by changing a B/C ratio of a boron solution which becomes sources of carbon and boron at the time a diamond film is generated, a concentration of boron doped in a diamond was changed, and then etching process was performed under the same conditions as the above-mentioned experiment. As a result, when a concentration of doped boron is less than approximately 1 × 10¹⁹ atoms/cm³, acicular projections are only non-uniformly and sparsely formed on the surface of a diamond film, as shown in an electron microscope image of FIG. 3. When a concentration of the doped boron is low, as a result of etching, projections are unevenly formed on the limited portions such as crystal grain boundary in the diamond film. The size and arrangement of the formed projections are not uniform, and also an array density is low. This showed that when a concentration of boron doped in a diamond is less than approximately 1 × 10¹⁹ atoms/cm³, a highly minute acicular projection array structure is not formed by performing etching.

As described above, the inventors of the present invention found that a structure in which acicular projections are regularly arranged can be formed on the surface of a diamond by performing etching using oxygen plasma, by controlling an amount of a dopant such as boron in a diamond. A dopant concentration suitable for obtaining an acicular projection array structure having better shape is approximately 3 × 10²⁰ atoms/cm³ to 8 × 10²¹ atoms/cm³.

According to the method for producing a diamond of First Embodiment, when an acicular projection array structure is formed, processes such as photolithography treatment are not necessary, thereby significantly improving productivity. In addition, since boron present near the surface of a diamond base material acts as a highly minute mask at an atomic level, an acicular projection array structure, in which minuteness and aspect ratio are significantly higher than those of acicular projections formed through lithography treatment, can be formed.

Furthermore, by changing a concentration of doped boron, an array density in a mask changes depending on an amount of boron present on the surface of a diamond. In short, by controlling a density of boron added to a diamond, an array density of acicular projections formed on the surface of a diamond can be controlled. Therefore, a diamond material having a suitable surface shape can be provided in accordance with an intended use. In addition, since the method for producing a diamond according to First Embodiment does not require processes such as photolithography treatment, the method is applicable to not only a two-dimensional material having a planar shape but also a three-dimensional material such as a spherical shaped material.

### [Second Embodiment]

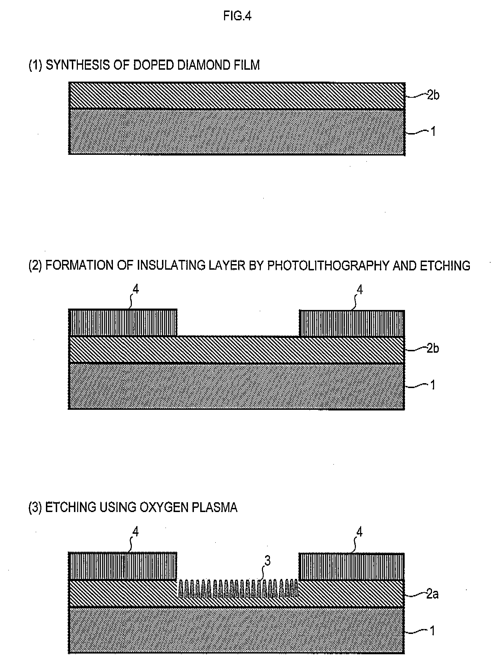

FIG. 4 is a schematic diagram showing a process for producing a diamond device applicable as an electronic device such as an electron emission device and a chemical sensor (Second Embodiment).

Firstly, as shown in FIG. 4(1), a doped diamond film 2b is generated on a substrate 1. An appropriate dopant, such as boron, nitrogen and phosphorus is incorporated into diamond, and the doped diamond film 2b is produced in accordance with an intended use of a diamond material to be produced. Next, as shown in FIG. 4(2), a pattern of an insulating layer 4 is formed through general-purpose photolithography and etching treatment on the surface of the generated doped diamond film 2b. Also, the patterning may be performed after a gate electrode or the like is further overlayered on the insulating layer 4. Then, as shown in FIG. 4(3), a plurality of acicular projections 3 are formed on an exposed portion of the doped diamond film 2b in a pattern of the formed insulating layer 4 through radio-frequency reactive ion etching using oxygen gas.

Thus, by combining a technology of forming a highly minute acicular projection array structure in the present invention on the surface of a diamond with a conventional photolithography technology, a portion in which an acicular projection array structure is to be formed can be patterned into a desired shape in accordance with an intended use of a diamond device to be produced.

For example, a highly minute acicular projection array structure can be selectively formed on a minute part due to a pattern of the insulating layer 4. A diamond device produced in this way has high energy intensity effect and improved electron emission efficiency when electrons are emitted. Also, in a case where a diamond device is applied as a chemical reaction sensor, since target compounds are radially attracted to the minute part on which an acicular projection array structure was formed, and a diamond projection has a very large reaction area on the surface thereof, reactive efficiency significantly improves. Therefore, the above-mentioned diamond device suitably acts as a chemical sensor.

Alternatively, as described in the above First Embodiment, after an acicular projection array structure is uniformly formed by etching using oxygen plasma on the surface of a diamond film to which a dopant is added, a process of forming a pattern of the insulating layer 4 or a gate electrode through photolithography and etching treatment may be performed.

By adequately combining a technology of forming a highly minute acicular array structure in the present invention with a photolithography technology, or by further performing a processing using other known technologies, an electrode and an electronic device having superior capabilities can be produced. For example, an electrode having a highly minute acicular projection array structure has superior electrode characteristics with larger surface area due to an acicular projection array structure having high minuteness and high aspect ratio. Therefore, the electrode is suitably applicable as a cathode for a lithium secondary battery, an electrode for a fuel cell, an electrode for ozone generation, an electrode for industrial electrolysis, an electrode for a chemical sensor, or an electrode for electron emission.

An electronic device having, as its constituents, a diamond material with a highly minute acicular projection structure has a drastically improved characteristics compared with the conventional electronic device, due to a larger surface area and superior electron emission capabilities. In particular, the diamond material is suitably applicable as a constituent of a lithium secondary battery, a fuel cell, an electric double layer capacitor, an electrolytic cell, and a chemical sensor.

### [Third Embodiment]

In the above-mentioned First and Second Embodiments, a dopant such as boron is added in a process of generating a diamond film. However, it may be also possible to incorporate a dopant to a specific site while controlling a dose amount by ion implantation or the like after a diamond synthesis, without adding a dopant in a process of generating a diamond through a chemical vapor deposition method or a high pressure high temperature synthetic method.

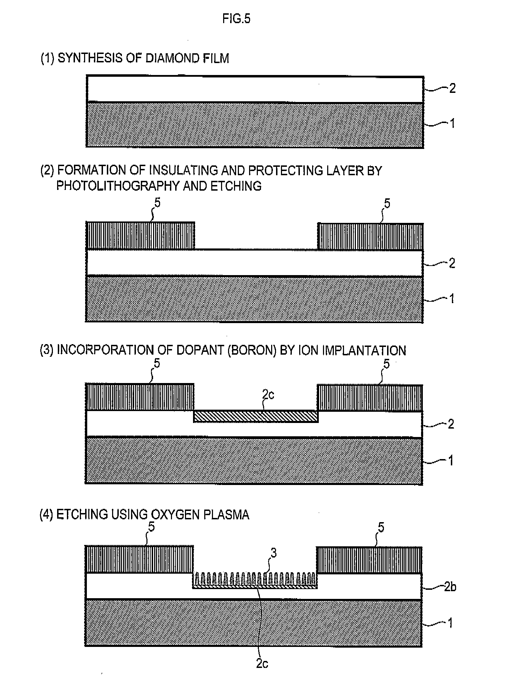

FIG. 5 is a schematic view showing a process of producing a diamond device in a case of forming acicular projections by adding a dopant through ion implantation after a diamond film synthesis (Third Embodiment).

Firstly, as shown in FIG. 5(1), a diamond film 2 (without doping) is synthesized on a substrate 1 by a micro-plasma CVD method. An example of the conditions for generating the film includes methane diluted with hydrogen into a concentration of 1 % to be supplied as a carbon source gas, a substrate temperature of 850°C , a pressure of 10 kPa, a micro wave frequency of 2.45 GHz, and a micro wave output of 8 kW. The diamond film 2 produced in this way is an insulator.

Next, as shown in FIG. 5(2), a pattern of an insulating and protecting layer 5 is formed by general-purpose photolithography and etching treatment.

Then, as shown in FIG. 5(3), a dopant is incorporated by ion implantation to an exposed portion of the diamond film 2 in the formed pattern of the insulating and protecting layer 5. A region indicated by a reference sign 2c in the figure is a diamond region where a dopant is incorporated. As a dopant, boron, nitrogen, aluminum, silicon, phosphorus, sulfur, copper, arsenic, molybdenum, platinum, gold or the like can be used. A region where a dopant is incorporated is near the surface which is approximately 0.1 to 0.5µm in depth from the surface of the diamond thin film 2. A concentration of a dopant in the region where a dopant is incorporated is suitably 1 × 10²¹ atoms/cm³ or so.

As shown in FIG. 5(4), radio-frequency reactive ion etching using oxygen gas is performed to a diamond region 2c to which a dopant has been doped to form a number of acicular projections 3 on an exposed part of the diamond film 2. Furthermore, the insulating and protecting layer 5 may be removed using an acid or alkaline solution thereafter.

Thus, an acicular projection array structure having a desired pattern can be selectively formed in accordance with an intended use of a diamond device to be produced, by forming a pattern by photolithography treatment and incorporating a dopant by ion implantation to the diamond surface region in the pattern.

### [Fourth Embodiment]

As shown in the above-mentioned First to Third Embodiments, the surface of diamond acicular projections formed by etching using oxygen plasma is oxygen-terminated. Therefore, by performing a process of irradiating hydrogen plasma to the formed acicular projections, the surface of acicular projections can be changed from oxygen-terminated to hydrogen-terminated.

In an experiment conducted by the inventors of the present invention with respect to a diamond film having an acicular projection array structure produced in the above-mentioned First Embodiment, the surface of acicular projections was treated for approximately 1 hour with hydrogen plasma excited by a micro wave having a frequency of 2.45 GHz under conditions in which a hydrogen gas pressure of 6.6 kPa and a substrate temperature of 800°C are maintained. When the surface of acicular projections was observed using a scanning electron microscope after the hydrogen plasma treatment, a shape of the surface was not changed by the treatment with hydrogen plasma.

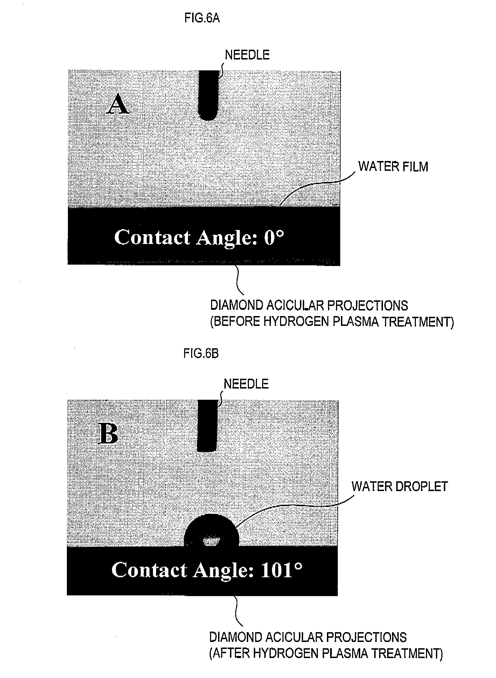

Additionally, a contact angle of water on the surface of acicular projections was compared before and after the hydrogen plasma treatment. FIG. 6A is a photograph showing that a water droplet was dropped using a needle on the surface of diamond acicular projections before the hydrogen plasma treatment. FIG. 6B is a photograph showing that a water droplet was dropped using a needle on the surface of diamond acicular projections after the hydrogen plasma treatment. As shown in FIG. 6A, on the surface of diamond acicular projections before the hydrogen plasma treatment, dropped water forms a water film with a contact angle of 0°. This indicates that the surface of diamond acicular projections before the hydrogen plasma treatment is hydrophilic. On the other hand, as shown in FIG. 6B, on the surface of diamond acicular projections after the hydrogen plasma treatment, dropped water forms a water droplet with a contact angle of 101° . This indicates that the surface of diamond acicular projections after the hydrogen plasma treatment is hydrophobic. Such changes of a water contact angle clearly show a fact that the surface of diamond acicular projections formed by etching using oxygen plasma, which was hydrophilic by being oxygen-terminated, is hydrogen-terminated through hydrogen plasma treatment, thereby to be hydrophobic. This fact shows that a termination of the surface of diamond acicular projections can be easily controlled by changing a gas species used for plasma treatment. Furthermore, the fact that the termination of the surface can be controlled shows, as in, for example, the above-mentioned example of a water contact angle, that physical properties each material has can be drastically changed. In short, a diamond device having desired physical properties can be produced in accordance with an intended use of a diamond device to be produced.

Especially, a hydrogen-terminated diamond has higher negative electron affinity than an oxygen-terminated diamond, showing high electron emission capabilities. In short, according to a hydrogen-terminated diamond device, an electron emission device having higher electron emission capabilities or the like can be provided.

As a gas species to be used for reforming the surface terminal of acicular projections, there fare nitrogen gas, chlorine gas, noble gas, perfluorocarbon gas, or the like, other than hydrogen gas. One of these gases may be used, or a plurality of these gases may be mixed to be used.

Although the embodiments of the present invention were described as above, the invention is not limited to the above-mentioned embodiments and can be embodied by various modifications within the scope of a gist of the invention.

For example, a material of a base substrate (a substrate 1 according to the above-mentioned embodiments) for synthesizing a diamond film is not limited to silicon, but may be monocrystal of molybdenum, tungsten, platinum, titanium, or diamond. A shape of a base substrate can be diverse, such as plate-shaped or mesh-shaped, as long as a diamond can be produced. Alternatively, a diamond base material for forming an acicular projection array structure may be freestanding without a base substrate or may be powdery or spherical diamond fine particles themselves.

Also properties of a diamond base material may be single crystal or polycrystal, and a plane direction of a single crystal is not specified.

## Claims

1. A method for producing a diamond having an acicular projection array structure on a surface thereof, comprising the step of forming the acicular projection array structure on a surface of a diamond base material by treating the surface of the diamond base material by dry etching using oxygen gas, wherein
at least one dopant selected among boron (B), nitrogen (N), aluminum (Al), silicon (Si), phosphorus (P), sulfur (S), copper (Cu), arsenic (As), molybdenum (Mo), platinum (Pt) and gold (Au) is doped with a concentration of 1 × 10¹⁹ atoms/cm³ and more at least in a region near the surface of the diamond base material.

2. The method for producing a diamond having an acicular projection array structure on a surface thereof according to claim 1, wherein the treatment of the surface of the diamond base material by dry etching is performed by reactive ion etching using radio-frequency as a plasma generating source in an oxygen gas atmosphere under a pressure of 5 to 100 Pa.

3. The method for producing a diamond having an acicular projection array structure on a surface thereof according to claim 1 or claim 2, wherein the doped diamond base material is a diamond to which the dopant is incorporated in a process of diamond synthesis.

4. The method for producing a diamond having an acicular projection array structure on a surface thereof according to claim 1 or claim 2, wherein the doped diamond base material is a diamond to which the dopant is incorporated by ion implantation after the diamond synthesis.

5. The method for producing a diamond having an acicular projection array structure on a surface thereof according to one of claim 1 to claim 4, wherein the method further includes a process in which, by applying at least one gas selected from oxygen gas, nitrogen gas, chlorine gas, noble gas, and perfluorocarbon gas to a surface of the formed acicular projections, a surface termination of the acicular projections is reformed by the gas species.

6. A diamond material produced by using the method for producing a diamond having an acicular projection array structure on a surface thereof according to one of claim 1 to claim 5.

7. An electrode including the diamond material produced by using the method for producing a diamond having an acicular projection array structure on a surface thereof according to one of claim 1 to claim 5.

8. The electrode according to claim 7, wherein the electrode is used as a cathode for a lithium secondary battery, an electrode for a fuel cell, an electrode for ozone generation, an electrode for industrial electrolysis, an electrode for a chemical sensor, or an electrode for electron emission.

9. An electronic device having, as its constituents, the diamond material produced by using the method for producing a diamond having an acicular projection array structure on a surface thereof according to one of claim 1 to claim 5.

10. The electronic device according to claim 9, wherein the electronic device is used as a lithium secondary battery, a fuel cell, an electric double layer capacitor, an electrolytic cell, a chemical sensor or an electron emission device.
